# EUROPEAN PATENT SPECIFICATION

(11) **EP 3 796 013 B1**
(45) Date of publication and mention of the grant of the patent: **02.08.2023**
(21) Application number: 19198097.8
(22) Date of filing: 18.09.2019
(51) Int. Cl.: G01R 31/28

(54) **INTERFACE ADAPTED TO RECEIVE A RADIO FREQUENCY PROBE FOR TESTING AN ELECTRIC DEVICE, AND METHOD FOR TESTING AN ELECTRIC DEVICE ARRANGED ON A SUBSTRATE**
ZUR AUFNAHME EINER RADIOFREQUENZSONDE ZUM TESTEN EINER ELEKTRISCHEN VORRICHTUNG KONFIGURIERTE SCHNITTSTELLE UND VERFAHREN ZUM TESTEN EINER AUF EINEM SUBSTRAT ANGEORDNETEN ELEKTRISCHEN VORRICHTUNG
INTERFACE CONÇUE POUR RECEVOIR UNE SONDE RADIOFRÉQUENCE POUR TESTER UN DISPOSITIF ÉLECTRIQUE ET PROCÉDÉ PERMETTANT DE TESTER UN DISPOSITIF ÉLECTRIQUE DISPOSÉ SUR UN SUBSTRAT

(43) Date of publication of application: 24.03.2021
(73) Proprietor: Infineon Technologies AG, 85579 Neubiberg (DE)
(72) Inventor: ENGELSBERGER, Franz Xaver, 83075 Bad Feilnbach (DE); Wojnowski, Maciej, 81735 München (DE)
(74) Representative: 2SPL Patentanwälte PartG mbB

(56) References cited:
- EP-A1- 2 745 301
- EP-A1- 3 182 618
- JP-A- 2018 137 296
- US-A1- 2006 145 308
- US-A1- 2010 041 361
- US-A1- 2013 277 803
- US-A1- 2015 145 098
- US-A1- 2018 006 618
- US-A1- 2019 120 876
- VASSILEV V ET AL: "ESD-RF co-design methodology for the state of the art RF-CMOS blocks", MICROELECTRONICS AND RELIABILITY, ELSEVIER SCIENCE LTD, GB, vol. 45, no. 2, 1 February 2005 (2005-02-01), pages 255-268, XP004708564, ISSN: 0026-2714, DOI: 10.1016/J.MICROREL.2004.05.013
- CHANG D-C ET AL: "K-Band Low-Noise Amplifiers Using 0.18>tex<$murm m$>/tex<CMOS Technology", IEEE MICROWAVE AND WIRELESS COMPONENTS LETTERS, IEEE SERVICE CENTER, NEW YORK, NY, US, vol. 14, no. 3, 1 March 2004 (2004-03-01), pages 106-108, XP011109481, ISSN: 1531-1309, DOI: 10.1109/LMWC.2004.825175

## Description

### Field

Examples relate to testing electric devices using Radio Frequency (RF) probes. In particular, examples relate to an electric system comprising an electric device arranged on a substrate. Further examples relate to a method for testing an electric device arranged on a substrate.

### Background

Document JP 2018 137296 A proposes a high frequency device suppressed in deterioration of high frequency characteristics due to a pad. Further, document US 2015/145098 A1 proposes a miniature passive structure for electrostatic discharge protection.

RF measurement of test devices on a system board requires so called launch structures (also known as launchers) for providing interconnection between RF probes and transmission lines on the board. Ideally, a launcher should be broadband and "transparent" for the measured signals. In other words, it should not introduce signal losses and signal reflections at the interface of the RF probe and the board.

Conventional RF launchers either do not show the required performance or show it only in a narrow frequency range.

### Summary

Hence, there may be a demand for an improved interface between an RF probe and an electronic device under test.

The demand may be satisfied by the subject matter of the appended claims.

An example relates to an electric system. The electric system comprises an electric device arranged on a substrate. Further, the electric device comprises an interface arranged on the substrate and adapted to receive a RF probe for testing the electric device. The interface comprises a first conductive structure for receiving at least one probe tip of the RF probe. The first conductive structure is coupled to a signal line in or on the substrate that couples to the electric device. Further, the interface comprises a second conductive structure for receiving at least one further probe tip of the RF probe; said second conductive structure being electrically coupled to the electric device by one or more vias of the substrate, in order to provide a reference signal to said electric device.

The interface additionally comprises a capacitive element for providing a compensation capacitance. The capacitive element and the first conductive structure are electrically coupled in order to form a compensation network for compensating RF parasitics. The first conductive structure extends lengthwise along a spatial axis. The capacitive element and the signal line are arranged on opposite sides of the first conductive structure along the spatial axis. The capacitive element comprises a MEMS capacitor configured to receive one or more control signals for adjusting an adjustable capacitance of the MEMS capacitor.

A further example relates to a method for testing an electric device arranged on a substrate. The method comprises placing a RF probe onto an interface arranged on the substrate such that a first conductive structure of the interface receives at least one probe tip of the RF probe and that a second conductive structure of the interface receives at least one further probe tip of the RF probe; said second conductive structure being electrically coupled to the electric device by one or more vias of the substrate, in order to provide a reference signal to said electric device.

The first conductive structure is coupled to a signal line in or on the substrate that couples to the electric device. The first conductive structure and a capacitive element for providing a compensation capacitance are electrically coupled in order to form a compensation network for compensating RF parasitics. The first conductive structure extends lengthwise along a spatial axis. The capacitive element and the signal line are arranged on opposite sides of the first conductive structure along the spatial axis. The capacitive element comprises a MEMS capacitor exhibiting an adjustable capacitance. The method further comprises supplying one or more control signals to the MEMS capacitor for adjusting the adjustable capacitance of the MEMS capacitor. The method additionally comprises applying a test signal to the interface via the at least one probe tip.

### Brief description of the Figures

Some examples of apparatuses and/or methods will be described in the following by way of example only, and with reference to the accompanying figures, in which
Fig. 1 illustrates a first example of an interface
Fig. 2 illustrates an example of an equivalent circuit for the example illustrated in Fig. 1;
Fig. 3 illustrates a second example of an interface;
Fig. 4 illustrates a third example of an interface;
Fig. 5 illustrates a fourth example of an interface;
Fig. 6 illustrates a fifth example of an interface;
Fig. 7 illustrates a sixth example of an interface;
Fig. 8 illustrates an exemplary reflection loss comparison between different interfaces;
Fig. 9 illustrates a flowchart of an example of a method for testing an electric device arranged on a PCB; and
Fig. 10 illustrates an exemplary set-up for a GSG measurement.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a", "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises", "comprising", "includes" and/or "including", when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

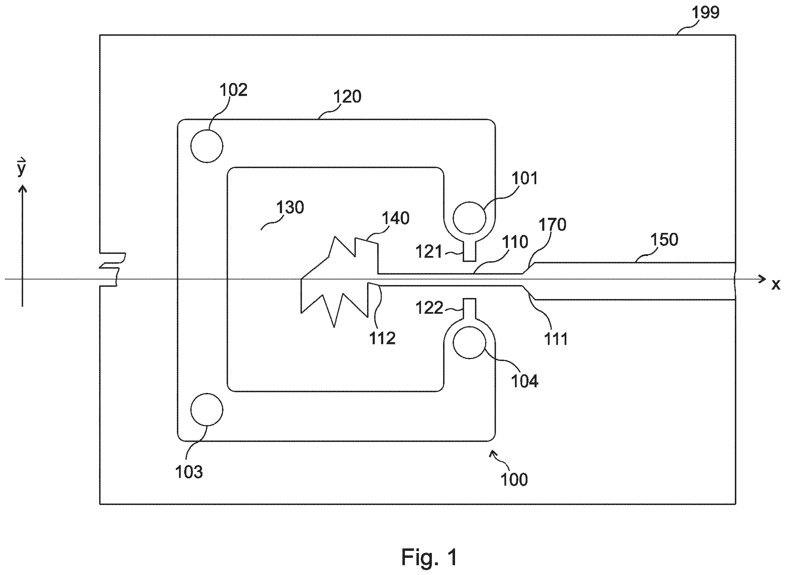

Fig. 1 illustrates an example of an interface 100 adapted to receive a RF probe (not illustrated) for testing an electric device (not illustrated) that is arranged on a same (test) substrate 199 as the interface 100. The substrate 199 serves as a substrate for the electric device and the interface 100. For example, the substrate 199 may be a Printed Circuit Board (PCB) or a glass substrate. The electric device may be understood as a Device Under Test (DUT). It is to be noted that the electric device may be mounted on the substrate 199 or be embedded within the substrate 199. The RF probe may, e.g., be a Ground-Signal-Ground (GSG) probe for RF testing the electric device.

The interface comprises a first conductive structure 110 for receiving at least one probe tip of the RF probe, and a second conductive structure 120 for receiving at least one further probe tip of the RF probe. The first conductive structure 110 and the second conductive structure 120 may be coplanar, i.e. be arranged in a same layer. Alternatively, the first conductive structure 110 and the second conductive structure 120 may be arranged in different layers. The first conductive structure 110 and the second conductive structure 120 may, e.g., be metal structures.

The second conductive structure 120 is for receiving a reference signal from the at least one further probe tip of the RF probe (e.g. a ground reference from two further probe tips of the RF probe). In order to provide the reference signal to the electric device, the second conductive structure 120 electrically couples to the electric device by one or more vias of the substrate. In the example of Fig. 1, the second conductive structure 120 electrically couples to four vias 101, 102, 103 and 104. Accordingly, the electric device may be coupled to a defined reference signal (e.g. a reference ground) while measuring/characterizing the electric device by means of the RF probe. The first conductive structure 110 is for receiving a test signal from the at least one probe tip of the RF probe. In other words, the at least one probe tip is used to apply a test signal to the interface 100 and, hence, the electric device. Therefore, the first conductive structure 110 is coupled at a first end 111 to a signal line 150 on the substrate 199 that couples to the electric device. In other words, the first conductive structure 110 is coupled to the electric device via the signal line 150. The signal line 150 is a conductive path routed on the substrate (e.g. the surface of the substrate). For example, the signal line 150 may be a MicroStrip Line (MSL).

It is to be noted that the above mentioned GSG probe is merely an example for an RF probe. In general any type of RF probe may be used. For example, an RF probe comprising only a probe tip for applying a test signal to the first conductive structure 110, and only one other probe tip for applying a reference signal to the second conductive structure 120 may be used. Further, it is to be noted that in alternative examples, one or more additional signal lines (e.g. coplanar to transmission line 150) may be used for coupling the second conductive structure 120 to the electric device instead of the vias illustrated in Fig. 1.

The first conductive structure 110 is for instance strip-shaped. The term "strip-shaped" is to be understood such that a dimension (extension) of an element such as first conductive structure 110 along a spatial axis is much greater (e.g. at least two, three, four, five, ten, twenty, fifty or one hundred times greater) than a dimension of the element along another spatial axis which is orthogonal to the spatial axis. In the example of Fig. 1, the first conductive structure 110 extends lengthwise along a spatial axis *̅x̅*̅ such that the dimension of the first conductive structure 110 along the spatial axis *̅x̅*̅ is much greater than the dimension of the first conductive structure 110 along the other spatial axis *̅y̅*̅ which is orthogonal to the spatial axis *̅x̅*̅.

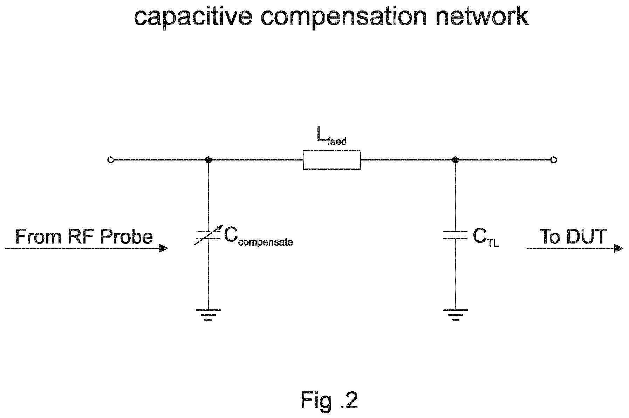

When the RF probe is placed on the first conductive structure 110, any conductive structure or material forming the signal path between the signal line 150 and the position at which the RF probe is placed on (touches) the first conductive structure 110 leads to a (small) series inductance L_{feed} (see Fig. 2). For example, part of the first conductive structure 110 as well as the short interconnection 170 between the first conductive structure 110 and the signal line 150 may cause the series inductance L_{feed} in the example of Fig. 1. The series inductance together with the capacitance C_{TL} of the signal line 150 causes unwanted RF parasitics at the interface. These RF parasitics become especially problematic when the dimensions of the interface 100 and/or the probe have an order of magnitude which is close or equal to that of the wavelength of the test signal (e.g. when they differ from two orders of magnitude or less or are of the same order of magnitude).

In order to overcome the parasitics, the interface 100 further comprises a capacitive element 140 for providing a compensation capacitance C_{compensate}. The capacitive element 140 and the first conductive structure 110 are electrically coupled in order to form a compensation network for compensating the RF parasitics. The capacitive element 140 is not in electrical contact with the second conductive structure 120 since the capacitive element 140 does not touch the second conductive structure 120. The capacitive element 140 electrically couples (is attached) to a second end 112 of the first conductive structure 110. As can be seen from Fig. 1, the capacitive element 140 and the signal line 150 are arranged on opposite sides of each of the first conductive structure 110 along the spatial axis *̅x̅*̅. In other words, a compensation capacitance C_{compensate} is added at the RF probe side of the structure illustrated in Fig. 1.

An equivalent circuit of the example depicted in Fig. 1 is illustrated in **Fig. 2****.** The inherent capacitance of the signal line 150 is represented by the capacitance C_{TL}.

The capacitive element 140 adds a compensation capacitance C_{compensate} such that the series inductance L_{feed} and the compensation capacitance C_{compensate} of the capacitive element 140 form an LC compensation network that allows to compensate at least in part for the unwanted RF parasitics caused by the series inductance L_{feed} and the capacitance C_{TL} of the signal line 150. In other words, the compensation capacitance C_{compensate} of the capacitive element 140 may allow to compensate for the series inductance L_{feed}. The compensation capacitance C_{com-pensate} of the capacitive element 140 may allow for a significantly increased bandwidth of the interface 100 compared to conventional launcher structures. In other words, the proposed incorporation of an LC compensation network into the launcher structure may allow to compensate for RF probe-to-substrate transition related parasitics.

In the example of Fig. 1, the second conductive structure 120 is formed integrally such that end portions 121 and 122 of the second conductive structure 120 are arranged on opposite sides of the spatial axis *̅x̅*̅. The second conductive structure 120 defines an inner space 130 within which the capacitive element 140 is arranged. All or part of the first conductive structure 110 may also be arranged within the inner space 130. Furthermore, the shape of the second conductive structure 120 is symmetrical with respect to the spatial axis *̅x̅*̅. It is to be noted that the respective locations of the vias 101, ... , 104 need not be symmetrical with respect to the spatial axis *̅x̅*̅. In alternative examples, the shape of the second conductive structure 120 may be asymmetrical with respect to the spatial axis *̅x̅*̅.

The capacitive element 140 may be implemented in many different ways. For example, the capacitive element 140 may be implemented with a fixed, predetermined capacitance or with an adjustable capacitance (e.g. depending on the frequency of the test signal to be applied via the first conductive structure 110). In the example of Fig. 1 which depicts a configuration in which the capacitance is fixed, the capacitive element 140 is a metal pad (patch) of a predefined capacitance (e.g. the desired compensation capacitance C_{compensate}). However, the capacitive element 140 may alternatively be formed by any other suitable electrically conductive material such as electrically conductive ceramics.

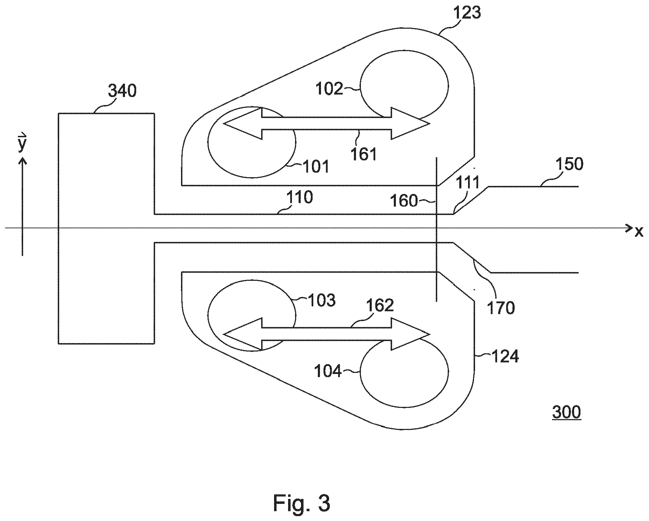

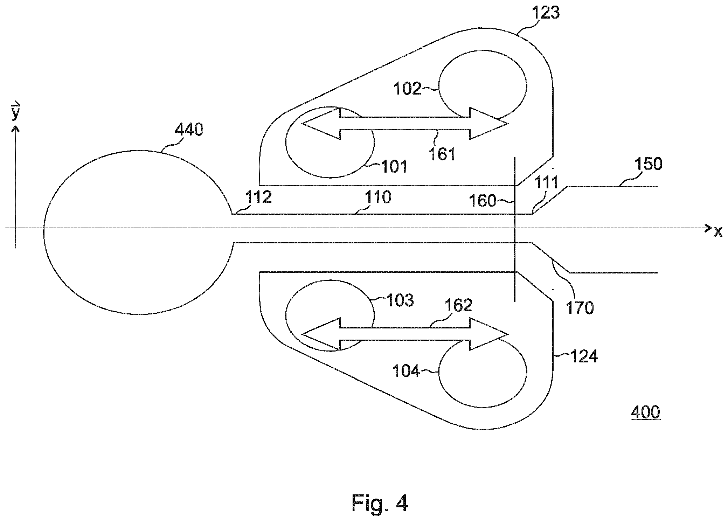

As can be seem from Fig. 1, the metal pad is irregularly shaped. It is to be noted that the capacitive element 140 may, in general, be of arbitrary shape. In other examples, the capacitive element may be of rectangular shape as indicated by the capacitive element 340 of interface 300 illustrated in **Fig. 3****.** In alternative examples, the capacitive element may be of circular shape as indicated by the capacitive element 440 of interface 400 illustrated in **Fig. 4****.**

In the example of Figs. 3 and 4, the second conductive structure 120 is not formed integrally, i.e. the second conductive structure 120 does not consist of a single conductive element. The second conductive structures of the interfaces 300 and 400 each comprise a first sub-structure 123 and a second sub-structure 124. The first and the second sub-structure 123, 124 are arranged on opposite sides of the spatial axis *̅x̅*̅ and are electrically separated from each other. Again, the capacitive element 140 is not in electrical contact with the first and the second sub-structure 123, 124 forming the second conductive structure as the capacitive element 140 does not touch the first and the second sub-structure 123, 124. As indicated in Figs. 3 and 4, shapes of the first and the second sub-structure 123, 124 may be symmetrical with respect to the spatial axis *̅x̅*̅. However, in alternative examples, the shapes of the first and the second sub-structure 123, 124 may be asymmetrical with respect to the spatial axis *̅x̅*̅. For example, due to the presence of another structure on the substrate, one of the first and the second sub-structure 123, 124 may be cut in order to have the shape of the respective sub-structure fit the position in which it needs to be placed. Symmetrical shapes may enable better performance, but are not necessary. The same holds for the integrally-formed second conductive structure 120 illustrated in Fig. 1. Similarly, the vias 101 to 104 may be placed in a non-symmetric manner, as indicated above.

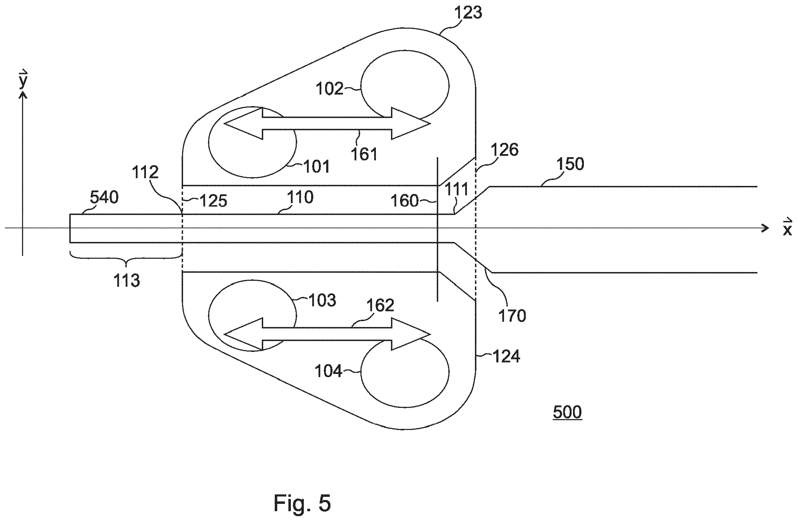

In alternative examples as illustrated in **Fig. 5****,** the first conductive structure 110 presents an extending portion 113 that extends along the spatial axis *̅x̅*̅ beyond vertical projections of the first and the second sub-structure 123, 124 onto the spatial axis *̅x̅*̅. The vertical projections of the first and the second sub-structure 123, 124 onto the spatial axis *̅x̅*̅ are indicated by dashed lines 125 and 126 in Fig. 5. At least part of the extending portion 113 forms the capacitive element 540. In the interface 500 of Fig. 5, the first conductive structure 110 is prolonged in order to provide a capacitive element 540 with the desired compensation capacitance C_{compen-sate} at an opposite end of the first conductive structure 110 compared to the interconnection 170 to the signal line 150. In other words, the capacitive element may be a lengthwise prolongation of the first conductive structure 110, whose dimension along the spatial axis is chosen so that the compensation capacitance exhibits a target value.

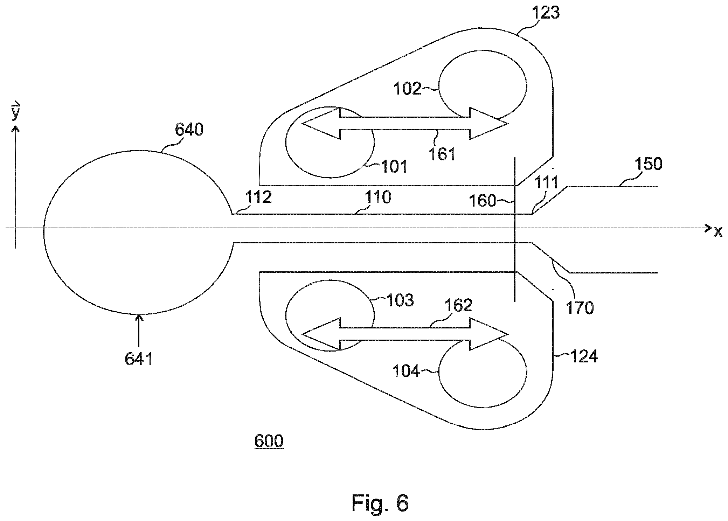

In other examples, the capacitive element may be (comprise) a (active) MEMS capacitor as illustrated in **Fig. 6.** Fig. 6 illustrates another interface 600 comprising a MEMS capacitor 640 coupled to the second end 112 of the first conductive structure 110. A MEMS capacitor is a capacitor manufactured in MicroElectroMechanical Systems (MEMS) technology. A distance (gap) between electrodes of the MEMS capacitor 640 is adjustable based on one or more control signals 641 (e.g. the number of control signal may depend on the implementation of the MEMS capacitor 640) for adjusting a capacitance of the MEMS capacitor 640 (e.g. to the desired compensation capacitance C_{compensate}). In other words, the MEMS capacitor 640 is configured to receive one or more control signals 641 for adjusting an adjustable capacitance of the MEMS capacitor 640 (e.g. the MEMS capacitance may be adjusted via DC biasing).

Further, as indicated in an exemplary manner by the arrows 161 and 162 in Figs. 3 to 6, the position of the RF probe along the longitudinal extension of the first conductive structure 110 (i.e. along the spatial axis *̅x̅*̅) may be varied to fine-tune the compensation capacitance. The position of the RF probe, i.e. the probe tips, on the interface is indicated by line 160 in Figs. 3 to 6. By shifting the position along the spatial axis *̅x̅*̅, the compensation capacitance C_{compen-sate} effectively seen by the RF probe may be fine-tuned. In other words, the smart grounding concept indicated by the arrows 161 and 162 may allow a fine-adjustment of the compensation capacitance.

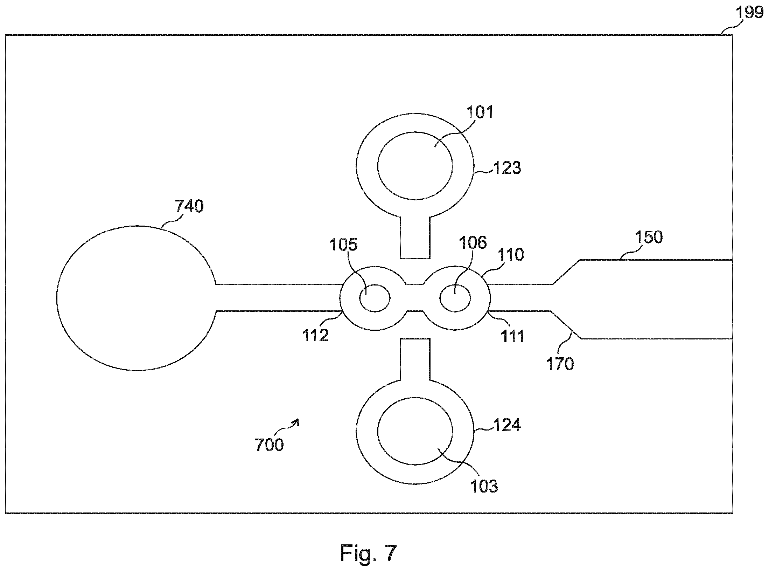

In the examples described above in connection with Figs. 1 and 3 to 6, the first conductive structure 110 is substantially strip-shaped. However, the first conductive structure 110 may in general exhibit any shape. An example of a dumbbell-shaped first conductive structure 110 is illustrated in **Fig. 7.** Fig. 7 illustrates another interface 700 comprising the dumbbell-shaped first conductive structure 110. Further, Fig. 7 illustrates that the individual elements of an interface according to the proposed technique may be arranged in different layers on the substrate. In the example of Fig. 7, the first conductive structure 110 and the sub-structure 123, 124 of the second conductive structure are arranged in the same layer (i.e. they are coplanar). The capacitive element 740 and the signal line 150 are arranged in two other layers. The first conductive structure 110 is in electrical contact with the capacitive element 740 and the signal line 150 via respective vias 105 and 106. Fig. 7 additionally illustrates that the number of vias coupled to the second conductive structure may be arbitrarily chosen. While in each of the examples described above in connection with Figs. 1 and 3 to 6 four vias are coupled to the second conductive structure, only two vias are coupled to the sub-structures 123 and 124 forming the second conductive structure. Also the shape of the sub-structures 123 and 124 varies compared to the examples described above in connection with Figs. 3 to 6. It is to be noted that the shapes of the sub-structures 123 and 124 may be chosen freely according to the proposed concept.

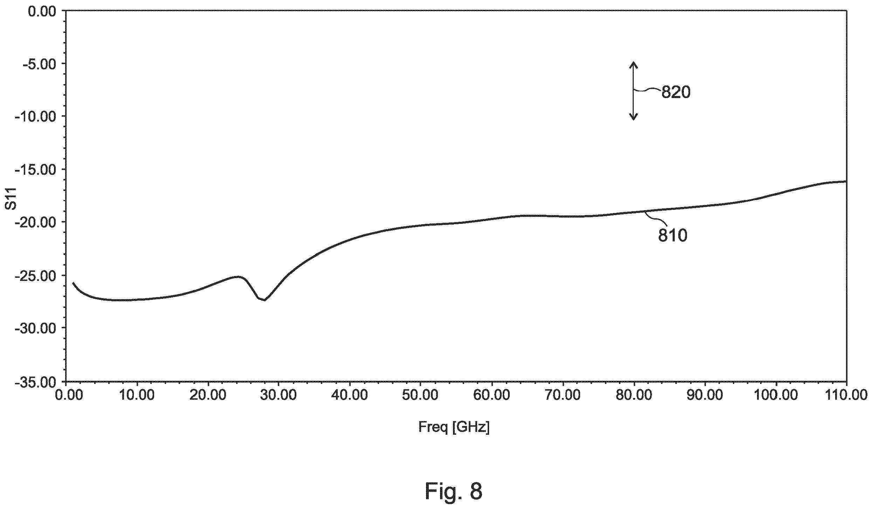

An effect of the proposed LC compensation network is illustrated in **Fig. 8.** Fig. 8 illustrates an exemplary comparison of the reflection losses for an interface according to the proposed technique and a conventional launcher structure.

The reflection loss for the interface according to the proposed technique is indicated by scattering parameter S₁₁ denoting the ratio between the signal power reflected by the interface and the signal power input to the interface. Line 810 represents the course of the scattering parameter S₁₁ for the interface over an exemplary frequency range from 0 GHz to 110 GHz. It is to be noted that the proposed LC compensation network is not limited to the exemplary frequency range illustrated in Fig. 8. In general, the proposed LC compensation network may be used for any frequency range.

As a reference, the reflection loss for a conventional launcher structure at a frequency of 80 GHz is indicated in Fig. 8 by means of double arrow 820. A conventional launcher structure typically shows a reflection loss of about -5 to -10 dB as indicated by the double arrow 820.

It can be seen from Fig. 8 that the proposed interface shows a reflection loss of about -19 dB. That is, the proposed interface is more "transparent" for measurement signals than a conventional launcher structure. Further, Fig. 8 shows that the reflection loss is well below -15 dB over the whole exemplary frequency range from 0 GHz to 110 GHz. The low reflection loss helps achieving a low insertion loss. Therefore, the proposed interface may allow broadband RF measurement/characterization of an electronic device with high performance (i.e. higher measurement accuracy).

An electric system comprising an electric device and an interface according to the proposed concept arranged on the same substrate may allow broadband RF measurement/characterization of the electronic device with high performance.

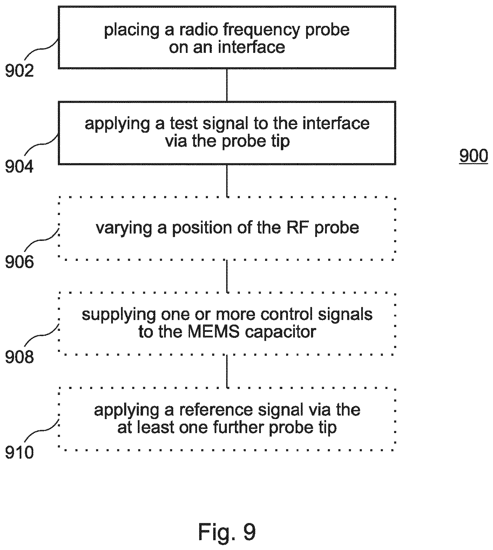

An example of a method 900 for testing an electric device arranged on a substrate according to the proposed technique is further illustrated in **Fig. 9****.** Method 900 comprises placing 902 a RF probe onto an interface as described above. In other words, method 900 comprises placing 902 a RF probe onto an interface arranged on the substrate such that a first conductive structure of the interface receives at least one probe tip of the RF probe and that a second conductive structure of the interface receives at least one further probe tip of the RF probe. The first conductive structure is coupled to a signal line on the substrate that couples to the electric device. The first conductive structure and a capacitive element for providing a compensation capacitance are electrically coupled in order to form a compensation network for compensating RF parasitics. Method 900 additionally comprises applying 904 a test signal to the interface via the at least one probe tip.

Using the proposed interface, method 900 may allow to overcome RF parasitics over a wide frequency range. Accordingly, method 900 may allow broadband RF measurement/characterization of the electronic device with high performance, i.e. low signal loss and signal reflections at the interface between the RF probe and the substrate.

As indicated above, the position of the RF probe along the interface may be varied in order to fine-tune the compensation capacitance. Method 900 may, hence, comprise varying 906 a position of the RF probe along a longitudinal extension of the first conductive structure.

If the capacitive element comprises a MEMS capacitor exhibiting an adjustable capacitance, method 900 may additionally comprise supplying 908 one or more control signals to the MEMS capacitor for adjusting the adjustable capacitance of the MEMS capacitor (e.g. to a predefined capacitance).

Further, the at least one further probe tip of the RF probe may be used for providing a reference signal such as a ground reference. Therefore, method 900 may optionally further comprise applying 910 a reference signal to the interface via the at least one further probe tip.

More details and aspects of method 900 are explained in connection with the proposed technique or one or more examples described above. Method 900 may comprise one or more additional optional features corresponding to one or more aspects of the proposed technique or one or more examples described above.

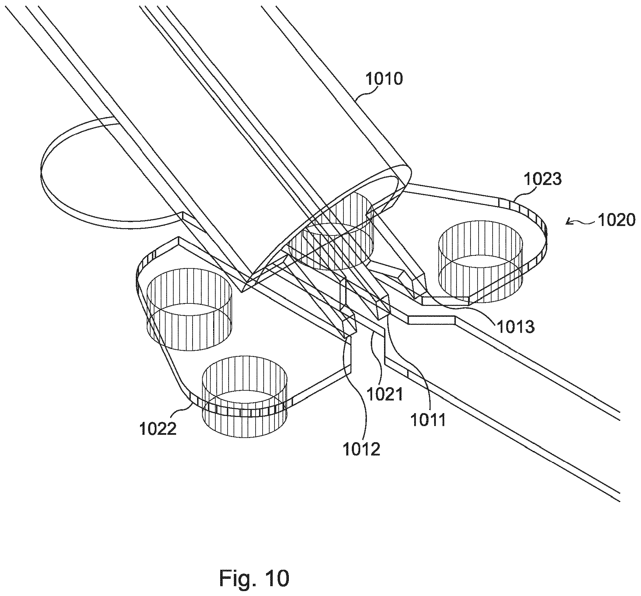

An exemplary set-up for a GSG measurement according to method 900 is illustrated in **Fig. 10****.** A RF probe 1010 is placed onto interface 1020 as described above in connection with Fig. 4. Accordingly, a first conductive structure 1021 of the interface receives the probe tip 1011 of the RF probe 1010. The second conductive structure of the interface 1020 comprises a first sub-structure 1022 and a second sub-structure 1023. Each of the first sub-structure 1022 and the second sub-structure 1023 receives a respective one of the further probe tips 1012 and 1013 of the RF probe 1010.

A test signal is applied to the interface 1020 via the probe tip 1011, wherein a ground reference (as an example of a reference signal) is applied to the interface via the further probe tips 1012 and 1013. The test signal and the ground reference is supplied to an electric device under test via the interface 1020 in accordance with method 900.

The examples as described herein may be summarized as follows:
Some examples relate to an interface adapted to receive a RF probe for testing an electric device that is arranged on a same substrate as the interface. The interface comprises a first conductive structure for receiving at least one probe tip of the RF probe. The first conductive structure is coupled to a signal line in or on the substrate that couples to the electric device. Further, the interface comprises a second conductive structure for receiving at least one further probe tip of the RF probe. The interface additionally comprises a capacitive element for providing a compensation capacitance. The capacitive element and the first conductive structure are electrically coupled in order to form a compensation network for compensating RF parasitics.

In some examples, the capacitive element is not in electrical contact with the second conductive structure.

According to some examples, the first conductive structure extends lengthwise along a spatial axis, wherein the capacitive element and the signal line are arranged on opposite sides of the first conductive structure along the spatial axis.

In some examples, the second conductive structure defines an inner space within which the capacitive element is arranged.

According to some examples, the second conductive structure is formed integrally such that end portions of the second conductive structure are arranged on opposite sides of the spatial axis.

In alternative examples, the second conductive structure comprises a first sub-structure and a second sub-structure, wherein the first and the second sub-structure are arranged on opposite sides of the spatial axis and are electrically separated from each other.

According to some examples, shapes of the first and the second sub-structure are symmetrical with respect to the spatial axis.

In some examples, shapes of the first and the second sub-structure are asymmetrical with respect to the spatial axis.

According to some examples, the first conductive structure presents an extending portion that extends along the spatial axis beyond vertical projections of the first and the second sub-structure onto the spatial axis, wherein at least part of the extending portion forms the capacitive element.

In some examples, the capacitive element is a pad of electrically conductive material.

In alternative examples, the capacitive element comprises a MEMS capacitor configured to receive one or more control signals for adjusting an adjustable capacitance of the MEMS capacitor.

According to some examples, the first conductive structure and the second conductive structure are coplanar.

In some examples, the second conductive structure electrically couples to one or more vias of the substrate coupled to the electric device.

Another example relates to an electric system comprising an electric device arranged on a substrate, and an interface as described herein which is arranged on the substrate.

A further example relates to a method for testing an electric device arranged on a substrate. The method comprises placing a RF probe onto an interface arranged on the substrate such that a first conductive structure of the interface receives at least one probe tip of the RF probe and that a second conductive structure of the interface receives at least one further probe tip of the RF probe. The first conductive structure is coupled to a signal line on the substrate that couples to the electric device. The first conductive structure and a capacitive element for providing a compensation capacitance are electrically coupled in order to form a compensation network for compensating RF parasitics. The method additionally comprises applying a test signal to the interface via the at least one probe tip.

According to some examples, the method further comprises varying a position of the at least one probe tip along a longitudinal extension of the first conductive structure.

In some examples, the capacitive element comprises a MEMS capacitor exhibiting an adjustable capacitance, wherein the method further comprises supplying one or more control signals to the MEMS capacitor for adjusting the adjustable capacitance of the MEMS capacitor.

According to some examples, the method further comprises applying a reference signal to the interface via the at least one further probe tip.

Examples according to the proposed technique may allow to overcome parasitics of an RF probe interface by usage of an LC compensation network.

The aspects and features mentioned and described together with one or more of the previously detailed examples and figures, may as well be combined with one or more of the other examples in order to replace a like feature of the other example or in order to additionally introduce the feature to the other example.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art.

A block diagram may, for instance, illustrate a high-level circuit diagram implementing the principles of the disclosure. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

## Claims

1. An electric system, comprising:
an electric device arranged on a substrate (199); and
an interface (100) arranged on the substrate (199) and adapted to receive a radio frequency probe for testing the electric device, the interface (100) comprising:
a first conductive structure (110) for receiving at least one probe tip of the radio frequency probe, wherein the first conductive structure (110) is coupled to a signal line (150) in or on the substrate (199) that couples to the electric device;
a second conductive structure (120) for receiving at least one further probe tip of the radio frequency probe; said second conductive structure being electrically coupled to the electric device by one or more vias of the substrate, in order to provide a reference signal to said electric device; and
a capacitive element (140) for providing a compensation capacitance,
wherein the capacitive element (140) and the first conductive structure (110) are electrically coupled in order to form a compensation network for compensating radio frequency parasitics,
wherein the first conductive structure (110) extends lengthwise along a spatial axis (*̅x̅*̅),
wherein the capacitive element (140) and the signal line (150) are arranged on opposite sides of the first conductive structure (110) along the spatial axis (*̅x̅*̅), and
wherein the capacitive element (140) comprises a MEMS capacitor (640) configured to receive one or more control signals (641) for adjusting an adjustable capacitance of the MEMS capacitor.

2. The electric system of claim 1, wherein the second conductive structure (120) defines an inner space within which the capacitive element (140) is arranged.

3. The electric system of claim 1 or claim 2, wherein the second conductive structure (120) is formed integrally such that end portions (121, 122) of the second conductive structure (120) are arranged on opposite sides of the spatial axis (*̅x̅*̅).

4. The electric system of claim 1, wherein the second conductive structure (120) comprises a first sub-structure (123) and a second sub-structure (124), wherein the first and the second sub-structure (123, 124) are arranged on opposite sides of the spatial axis (*̅x̅*̅) and are electrically separated from each other.

5. The electric system of claim 4, wherein shapes of the first and the second sub-structure (123, 124) are symmetrical with respect to the spatial axis (*̅x̅*̅).

6. The electric system of claim 4 or claim 5, wherein the first conductive structure (110) presents an extending portion (113) that extends along the spatial axis (*̅x̅*̅) beyond vertical projections of the first and the second sub-structure (123, 124) onto the spatial axis (*̅x̅*̅), and wherein at least part of the extending portion (113) forms the capacitive element (140).

7. The electric system of any of claim 1 to 6, wherein the capacitive element (140) is a pad of electrically conductive material.

8. The electric system of any of claims 1 to 7, wherein the first conductive structure (110) and the second conductive structure (120) are coplanar.

9. A method (900) for testing an electric device arranged on a substrate, the method (900) comprising:
placing (902) a radio frequency probe onto an interface arranged on the substrate such that a first conductive structure of the interface receives at least one probe tip of the radio frequency probe and that a second conductive structure of the interface receives at least one further probe tip of the radio frequency probe; said second conductive structure being electrically coupled to the electric device by one or more vias of the substrate, in order to provide a reference signal to said electric device, wherein the first conductive structure is coupled to a signal line in or on the substrate that couples to the electric device, wherein the first conductive structure and a capacitive element for providing a compensation capacitance are electrically coupled in order to form a compensation network for compensating radio frequency parasitics, wherein the first conductive structure extends lengthwise along a spatial axis, wherein the capacitive element and the signal line are arranged on opposite sides of the first conductive structure along the spatial axis, and wherein the capacitive element comprises a MEMS capacitor exhibiting an adjustable capacitance;
supplying one or more control signals to the MEMS capacitor for adjusting the adjustable capacitance of the MEMS capacitor; and
applying (904) a test signal to the interface via the at least one probe tip.

10. The method (900) of claim 9, further comprising:
varying (906) a position of the at least one probe tip along a longitudinal extension of the first conductive structure.

11. The method (900) of claim 9 or claim 10, further comprising:
applying (910) a reference signal to the interface via the at least one further probe tip.

## Patentansprüche

1. Ein elektrisches System, umfassend:
eine elektrische Vorrichtung, die auf einem Substrat (199) angeordnet ist; und
eine Schnittstelle (100), die auf dem Substrat (199) angeordnet ist und angepasst ist, eine Hochfrequenzsonde zum Testen der elektrischen Vorrichtung zu empfangen, wobei die Schnittstelle (100) umfasst:
eine erste leitfähige Struktur (110) zum Empfangen von zumindest einer Sondenspitze der Hochfrequenzsonde, wobei die erste leitfähige Struktur (110) mit einer Signalleitung (150) in oder auf dem Substrat (199) gekoppelt ist, die mit der elektrischen Vorrichtung koppelt;
eine zweite leitfähige Struktur (120) zum Empfangen von zumindest einer weiteren Sondenspitze der Hochfrequenzsonde; wobei die zweite leitfähige Struktur durch ein oder mehrere Vias des Substrats elektrisch mit der elektrischen Vorrichtung gekoppelt ist, um ein Referenzsignal an die elektrische Vorrichtung bereitzustellen; und
ein kapazitives Element (140) zum Bereitstellen einer Kompensationskapazität,
wobei das kapazitive Element (140) und die erste leitfähige Struktur (110) elektrisch gekoppelt sind, um ein Kompensationsnetzwerk zum Kompensieren von Hochfrequenz-Störeffekten zu bilden,
wobei sich die erste leitfähige Struktur (110) in Längsrichtung entlang einer Raumachse (*̅x̅*̅) erstreckt,
wobei das kapazitive Element (140) und die Signalleitung (150) auf gegenüberliegenden Seiten der ersten leitfähigen Struktur (110) entlang der Raumachse (*̅x̅*̅) angeordnet sind, und
wobei das kapazitive Element (140) einen MEMS-Kondensator (640) umfasst, der ausgebildet ist, ein oder mehrere Steuersignale (641) zum Einstellen einer einstellbaren Kapazität des MEMS-Kondensators zu empfangen.

2. Das elektrische System gemäß Anspruch 1, wobei die zweite leitfähige Struktur (120) einen Innenraum definiert, in dem das kapazitive Element (140) angeordnet ist.

3. Das elektrische System gemäß Anspruch 1 oder Anspruch 2, wobei die zweite leitfähige Struktur (120) einstückig derart gebildet ist, dass Endabschnitte (121, 122) der zweiten leitfähigen Struktur (120) auf gegenüberliegenden Seiten der Raumachse (*̅x̅*̅) angeordnet sind.

4. Das elektrische System gemäß Anspruch 1, wobei die zweite leitfähige Struktur (120) eine erste Teilstruktur (123) und eine zweite Teilstruktur (124) umfasst, wobei die erste und die zweite Teilstruktur (123, 124) auf gegenüberliegenden Seiten der Raumachse (*̅x̅*̅) angeordnet und elektrisch voneinander getrennt sind.

5. Das elektrische System gemäß Anspruch 4, wobei Formen der ersten und der zweiten Teilstruktur (123, 124) symmetrisch in Bezug auf die Raumachse (*̅x̅*̅) sind.

6. Das elektrische System gemäß Anspruch 4 oder Anspruch 5, wobei die erste leitfähige Struktur (110) einen Erstreckungsabschnitt (113) aufweist, der sich entlang der Raumachse (*̅x̅*̅) über vertikale Projektionen der ersten und der zweiten Teilstruktur (123, 124) hinaus auf die Raumachse (*̅x̅*̅) erstreckt, und wobei zumindest ein Teil des Erstreckungsabschnitts (113) das kapazitive Element (140) bildet.

7. Das elektrische System gemäß einem der Ansprüche 1 bis 6, wobei das kapazitive Element (140) eine Anschlussfläche aus elektrisch leitfähigem Material ist.

8. Das elektrische System gemäß einem der Ansprüche 1 bis 7, wobei die erste leitfähige Struktur (110) und die zweite leitfähige Struktur (120) koplanar sind.

9. Ein Verfahren (900) zum Testen einer elektrischen Vorrichtung, die auf einem Substrat angeordnet ist, wobei das Verfahren (900) umfasst:
Platzieren (902) einer Hochfrequenzsonde auf eine auf dem Substrat angeordnete Schnittstelle, derart, dass eine erste leitfähige Struktur der Schnittstelle zumindest eine Sondenspitze der Hochfrequenzsonde empfängt und dass eine zweite leitfähige Struktur der Schnittstelle zumindest eine weitere Sondenspitze der Hochfrequenzsonde empfängt; wobei die zweite leitfähige Struktur durch ein oder mehrere Vias des Substrats elektrisch mit der elektrischen Vorrichtung gekoppelt ist, um ein Referenzsignal an die elektrische Vorrichtung bereitzustellen, wobei die erste leitfähige Struktur mit einer Signalleitung in oder auf dem Substrat gekoppelt ist, die mit der elektrischen Vorrichtung koppelt, wobei die erste leitfähige Struktur und ein kapazitives Element zum Bereitstellen einer Kompensationskapazität elektrisch gekoppelt sind, um ein Kompensationsnetzwerk zum Kompensieren von Hochfrequenz-Störeffekten zu bilden, wobei sich die erste leitfähige Struktur in Längsrichtung entlang einer Raumachse erstreckt, wobei das kapazitive Element und die Signalleitung auf gegenüberliegenden Seiten der ersten leitfähigen Struktur entlang der Raumachse angeordnet sind, und wobei das kapazitive Element einen MEMS-Kondensator, der eine einstellbare Kapazität aufweist, umfasst;
Liefern eines oder mehrerer Steuersignale an den MEMS-Kondensator zum Einstellen der einstellbaren Kapazität des MEMS-Kondensators; und
Anwenden (904) eines Testsignals auf die Schnittstelle über die zumindest eine Sondenspitze.

10. Das Verfahren (900) gemäß Anspruch 9, ferner umfassend:
Variieren (906) einer Position der zumindest einen Sondenspitze entlang einer länglichen Erstreckung der ersten leitfähigen Struktur.

11. Das Verfahren (900) gemäß Anspruch 9 oder 10, ferner umfassend:
Anwenden (910) eines Referenzsignals auf die Schnittstelle über die zumindest eine weitere Sondenspitze.

## Revendications

1. Système électrique comprenant :
un dispositif électrique disposé sur un substrat (199) ; et
une interface (100) disposée sur le substrat (199) et adaptée pour recevoir une sonde de fréquence radio pour tester le dispositif électrique, l'interface (100) comprenant :
une première structure conductrice (110) pour recevoir au moins une pointe de sonde de la sonde de fréquence radio, la première structure conductrice (110) étant couplée à une ligne de signal (150) dans ou sur le substrat (199) qui est couplée au dispositif électrique ;
une deuxième structure conductrice (120) pour recevoir au moins une autre pointe de sonde de la sonde de fréquence radio ; ladite deuxième structure conductrice étant couplée électriquement au dispositif électrique par un ou plusieurs vias du substrat, afin de fournir un signal de référence audit dispositif électrique ; et
un élément capacitif (140) pour fournir une capacité de compensation,
dans lequel l'élément capacitif (140) et la première structure conductrice (110) sont couplés électriquement afin de former un réseau de compensation pour compenser des parasites de fréquence radio,
dans lequel la première structure conductrice (110) s'étend dans le sens de la longueur le long d'un axe spatial (*̅x̅*̅),
dans lequel l'élément capacitif (140) et la ligne de signal (150) sont disposés sur des côtés opposés de la première structure conductrice (110) le long de l'axe spatial (*̅x̅*̅), et
dans lequel l'élément capacitif (140) comprend un condensateur MEMS (640) configuré pour recevoir un ou plusieurs signaux de commande (641) afin d'ajuster une capacité réglable du condensateur MEMS.

2. Système électrique selon la revendication 1, dans lequel la deuxième structure conductrice (120) définit un espace intérieur dans lequel l'élément capacitif (140) est disposé.

3. Système électrique selon la revendication 1 ou la revendication 2, dans lequel la deuxième structure conductrice (120) est formée intégralement de telle sorte que les parties d'extrémité (121, 122) de la deuxième structure conductrice (120) sont disposées sur des côtés opposés de l'axe spatial (*̅x̅*̅).

4. Système électrique selon la revendication 1, dans lequel la deuxième structure conductrice (120) comprend une première sous-structure (123) et une deuxième sous-structure (124), dans lequel la première et la deuxième sous-structure (123, 124) sont disposées sur des côtés opposés de l'axe spatial (*̅x̅*̅) et sont électriquement séparées l'une de l'autre.

5. Système électrique selon la revendication 4, dans lequel les formes de la première et de la deuxième sous-structure (123, 124) sont symétriques par rapport à l'axe spatial (*̅x̅*̅).

6. Système électrique selon la revendication 4 ou la revendication 5, dans lequel la première structure conductrice (110) présente une partie d'extension (113) qui s'étend le long de l'axe spatial (*̅x̅*̅) au-delà des projections verticales de la première et de la deuxième sous-structure (123, 124) sur l'axe spatial (*̅x̅*̅), et dans lequel au moins une section de la partie d'extension (113) forme l'élément capacitif (140).

7. Système électrique selon l'une des revendications 1 à 6, dans lequel l'élément capacitif (140) est un surface de connexion de matériau électroconducteur.

8. Système électrique selon l'une des revendications 1 à 7, dans lequel la première structure conductrice (110) et la deuxième structure conductrice (120) sont coplanaires.

9. Procédé (900) pour tester un dispositif électrique disposé sur un substrat, le procédé (900) comprenant le fait de :
placer (902) une sonde de fréquence radio sur une interface disposée sur le substrat de telle sorte qu'une première structure conductrice de l'interface reçoive au moins une pointe de sonde de la sonde de fréquence radio et qu'une deuxième structure conductrice de l'interface reçoive au moins une autre pointe de sonde de la sonde de fréquence radio ; ladite deuxième structure conductrice étant couplée électriquement au dispositif électrique par un ou plusieurs vias du substrat, afin de fournir un signal de référence audit dispositif électrique, la première structure conductrice étant couplée à une ligne de signal dans ou sur le substrat qui est couplée au dispositif électrique, la première structure conductrice et un élément capacitif pour fournir une capacité de compensation étant couplés électriquement afin de former un réseau de compensation pour compenser des parasites de fréquence radio, la première structure conductrice s'étendant dans le sens de la longueur le long d'un axe spatial, l'élément capacitif et la ligne de signal étant disposés sur des côtés opposés de la première structure conductrice le long de l'axe spatial, et l'élément capacitif comprenant un condensateur MEMS présentant une capacité réglable ;
fournir un ou plusieurs signaux de commande au condensateur MEMS afin d'ajuster la capacité réglable du condensateur MEMS ; et
appliquer (904) un signal de test à l'interface par l'intermédiaire de l'au moins une pointe de sonde.

10. Procédé (900) selon la revendication 9, comprenant en outre le fait de :
varier (906) une position de l'au moins une pointe de sonde le long d'une extension longitudinale de la première structure conductrice.

11. Procédé (900) selon la revendication 9 ou la revendication 10, comprenant en outre le fait de :
appliquer (910) un signal de référence à l'interface par l'intermédiaire de l'au moins une autre pointe de sonde.
